(19) Europäisches Patentamt
European Patent Office
Office européen des brevets

(11) Publication number: 0 369 645 A1

(12) # EUROPEAN PATENT APPLICATION

(21) Application number: 89311352.2

(22) Date of filing: 02.11.89

(51) Int. Cl.5: G03F 7/029

(30) Priority: 17.11.88 US 272520

(43) Date of publication of application:
23.05.90 Bulletin 90/21

(84) Designated Contracting States:
BE DE FR GB IT NL

(71) Applicant: MINNESOTA MINING AND MANUFACTURING COMPANY
3M Center, P.O. Box 33427
Saint Paul, MN 55133- 3427(US)

(72) Inventor: Ubel, Frank Andrew, III c/o
Minnesota Mining and
Manufacturing Company 2501 Hudson Road
St. Paul Minnesota 55144-1000(US)
Inventor: Busman, Stanley C. c/o Minnesota
Mining and
Manufacturing Company 2501 Hudson Road
St. Paul Minnesota 55144-1000(US)
Inventor: Ali, Mohammad Z. c/o Minnesota
Mining and
Manufacturing Company 2501 Hudson Road
St. Paul Minnesota 55144-1000(US)

(74) Representative: Baillie, Iain Cameron et al
c/o Ladas & Parry Isartorplatz 5
D-8000 München 2(DE)

(54) **Triazine photoinitiators in a ternary system for addition polymerization.**

(57) Photocurable addition-polymerizable compositions containing a free-radically-polymerizable monomer and a photoinitiator system containing i) a trihalomethyl substituted-s-triazine ii) a sensitizing compound, and iii) an electron donor having an oxidation potential that is greater than zero and less than or equal to that of p-dimethoxybenzene (1.32 volts vs. S.C.E.). The compositions cure rapidly and deeply under ultraviolet or visible light.

EP 0 369 645 A1

# TRIAZINE PHOTOINITIATORS IN A TERNARY SYSTEM FOR ADDITION POLYMERIZATION

## BACKGROUND TO THE INVENTION

### Field of Invention

This invention relates to photoinitiator systems for use in addition (free radically-initiated) polymerization.

### Background of the Art

Triazines of structure I (R = alkyl, $-CX_3$; X = Cl, Br) have been previously described for use as photoinitiators in addition-polymerizable compositions. References relating to such compositions include U.S. Pat. Nos. 3,617,288, 3,640,718, 3,729,313, 3,741,769, 3,808,006, 4,259,432, 4,505,793, 4,584,260; European Pub. Pat. Appl. No. 109,291; Japanese Pat. Appl. Nos. JP 58/15,503 and JP 58/40,302 A2 and Chem. Abs. 100: 15,325S.

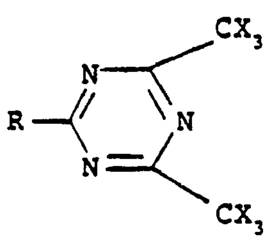

(I)

Three component or ternary photoinitiator systems composed of diaryliodonium salts, sensitizer, and electron donor have been described in co-pending U.S. Pat. Appl. No. 34,065, filed on April 4, 1987.

Mono- and di-ketones have also previously been described for use as photoinitiators in addition-polymerizable compositions. References relating to such compositions include U.S. Pat. No. 3,427,161, 3,756,827, 3,759,807 and 4,071,424; U.K. Pat. Specification No. 1,304,112; European Published Pat. Appl. No. 150,952 and Chem. Abs. 95:225704H.

a) "Free-radical Chemistry", by D.C. Nonhebel and J.C Walton, University Press (1974).

b) "Light Sensitive Systems", by J. Kosar, J. Wiley & Sons,Inc. (1965).

## SUMMARY OF THE INVENTION

The present invention provides, in one aspect, an addition-polymerizable composition comprising;

(a) at least one free-radically-polymerizable monomer ("monomer"), and

(b) a photoinitiator system, compatible (i.e., dispersible or soluble) in said monomer, comprising photochemically effective amounts of:

i) trihalomethyl-substituted 1,3,5-triazine ("triazine"),

ii) sensitizing compound ("sensitizer") capable of absorbing some radiation within the range of wavelengths between about 300 and about 1000 nanometers and capable of sensitizing 2-methyl-4,6-bis-(trichloromethyl)-s-triazine, and

iii) at least one electron donor compound ("donor"), the oxidation potential of said donor compound being greater than zero and less than that of paradimethoxybenzene, said donor being different from said sensitizer [and said triazine.] and wherein (zero) $< E_{ox}$ (donor) $< E_{ox}$ (p-dimethoxybenzene)

The compositions of the invention provide a very useful combination of cure speed, cure depth and shelf life. They cure well even when loaded with large amounts of fillers, and can be used in a variety of applications including graphic arts imaging (e.g., for color proofing systems, curable inks, or silverless

imaging), printing plates (e.g., projection plates or laser plates), photoresists, solder masks, coated abrasives, magnetic media, photocurable adhesives (e.g., for orthodontics) and photocurable composites (e.g., for autobody repair or dentistry).

These compositions may also be encapsulated for imaging applications as taught in U.S. Pat. Nos. 4,399,209, 4,440,846, and European Pat. Appl. No. 223,587 Al.

The invention also provides a method for preparing photopolymerized compositions, and polymerized articles made therefrom.

## DETAILED DESCRIPTION OF THE INVENTION

A wide variety of monomers can be photopolymerized using the photoinitiator system of the invention. Suitable monomers contain at least one ethylenically-unsaturated double bond, can be oligomers, and are capable of undergoing addition polymerization. Such monomers include mono-, di- or poly- acrylates and methacrylates such as methyl acrylate, methyl methacrylate, ethyl acrylate, isopropyl methacrylate, n-hexyl acrylate, stearyl acrylate, allyl acrylate, glycerol diacrylate, glycerol triacrylate, ethyleneglycol diacrylate, diethyleneglycol diacrylate, triethyleneglycol dimethacrylate, 1,3-propanediol diacrylate, 1,3-propanediol dimethacrylate, trimethylolpropane triacrylate, 1,2,4-butanetriol trimethacrylate, 1,4-cyclohexanediol diacrylate, pentaerythritol triacrylate, pentaerythritol tetraacrylate, pentaerythritol tetramethacrylate, sorbitol hexacrylate, bis[1-(2-acryloxy)]-p-ethoxyphenyldimethylmethane, bis[1-(3-acryloxy-2-hydroxy)]-p-propoxyphenyl-dimethylmethane, trishydroxyethylisocyanurate trimethyacrylate; bisphenol A diglycidyl ether dimethacrylate, the bis-acrylates and bis-methacrylates of polyethylene glycols of molecular weight 200-500, copolymerizable mixtures of acrylated monomers such as those of U.S. Pat. No. 4,652,274, and acrylated oligomers such as those of U.S. Pat. No. 4,642,126; unsaturated amides such as methylene bis-acrylamide, methylene bis-methacrylamide, 1,6-hexamethylene bis-acrylamide, diethylene triamine tris-acrylamide and beta-methacrylaminoethyl methacrylate; and vinyl compounds such as styrene, diallyl phthalate, divinyl succinate, divinyl adipate and divinylphthalate. Mixtures of two or more monomers can be used if desired.

The monomer is combined with a three component or ternary photoinitiator system. The first component in the photoinitiator system is the trihalomethyl substituted 1,3,5-triazine. The triazine should be soluble in the monomer and preferably is shelf-stable (i.e., does not spontaneously promote polymerization) when dissolved or dispersed therein in the presence of the sensitizer and doncr. Accordingly, selection of a particular triazine may depend to some extent upon the particular monomer, sensitizer, and donor chosen. Compatibility merely indicates that the compounds can be placed in such physical association that they can chemically interact or react.

Suitable triazines are described in U.S. Pat. Nos. 3,617,288, 3,729,313, and 4,259,432 and copending U.S. Patent Applications Serial Nos. , , , and , filed on September 7, 1988 and bearing Attorney's Docket Nos. 42685, 42686, 42687, and 42687 (with computer recognition suffixes U.S.A. #A). Preferred triazines have the structure

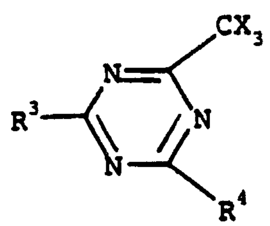

where X is Cl or Br, $R^3$,$R^4$ are independently $CX_3$, $R^5$, $R^5NH$-, or $R^5CONH$-, wherein $R^5$ is alkyl of 1 to 8 carbons, substituted alkyl of not more than 12 carbons, phenyl, substituted phenyl of not more than 12 carbon atoms, naphthyl, or substituted naphthyl of not more than 14 carbons. Most preferred triazines are 2-methyl-4,6-bis(trichloromethyl)-1,3,5-triazine and 2,4,6-tris(trichloromethyl)-1,3,5-triazine.

The second component in the photoinitiator system is the sensitizer. The sensitizer should be soluble in the monomer, and is capable of radiation absorption somewhere within the range of wavelengths between about 300 and about 1000 nanometers, more preferably about 350 and about 800 nanometers and most preferably about 350 to about 700 nanometers. The sensitizer is also capable of sensitizing 2-methyl-4,6-bis(trichloromethyl)-s-triazine, using the test procedure described in U.S. Pat. No. 3,729313. Using currently

available materials, that test is carried out as follows. A standard test solution is prepared having the following composition:

5.0 parts of a 5% (weight by volume) solution in methanol of 45,000-55,000 molecular weight, 9.0-13.0% hydroxyl content, polyvinyl butyral ("Butvar B76", Monsanto)

0.3 parts trimethylolpropane trimethacrylate

0.03 parts 2-methyl-4,6-bis(trichloromethyl)-s-triazine (see Bull. Chem. Soc. Japan, 42, 2924-2930, 1969).

To this solution is added 0.01 parts of the compound to be tested as a sensitizer. The solution is knife-coated onto a 0.05mm thick clear polyester film using a knife orifice of 0.05mm, and the coating is air dried for about 30 minutes. A 0.05mm clear polyester cover film is carefully placed over the dried but soft and tacky coating with minimum entrapment of air. The resulting sandwich construction is then exposed for three minutes to 161,000 Lux of incident light from a tungsten light source providing light in both the visible and ultraviolet range ("FCH" 650 watt quartz-iodine lamp, General Electric).

Exposure is made through a stencil so as to provide exposed and unexposed areas in the construction. After exposure the cover film is removed and the coating is treated with a finely divided colored powder, such as a color toner powder of the type conventionally used in xerography. If the tested compound is a sensitizer, the trimethylolpropane trimethacrylate monomer will be polymerized in the light-exposed areas by the light-generated free radicals from the 2-methyl-4,6-bis(trichloromethyl)-s-triazine. Since the polymerized areas will be essentially tack-free, the colored powder will selectively adhere only to the tacky, unexposed areas of the coating, providing a visual image corresponding to that in the stencil. If there are problems with solvent compatability in this test with any particular sensitizer, the solvent may be varied to meet solubility requirements without altering the nature of the test or the invention.

Preferably, in addition to passing the above test, a sensitizer is also selected based in part upon shelf stability considerations. Accordingly, selection of a particular sensitizer may depend to some extent upon the particular monomer, triazine and donor chosen.

Suitable sensitizers are believed to include compounds in the following categories: ketones, coumarin dyes (e.g., ketocoumarins), xanthene dyes, 3H-xanthen-3-one dyes, acridine dyes, thiazole dyes, thiazine dyes, oxazine dyes, azine dyes, aminoketone dyes, methine and polymethines dyes, porphyrins, aromatic polycyclic hydrocarbons, p-substituted aminostyryl ketone compounds, aminotriaryl methanes, merocyanines, squarylium dyes and pyridinium dyes. Ketones (e.g., monoketones or alpha-diketones), ketocoumarins, aminoarylketones, p-substituted aminostyryl ketone compounds, cyanines, merocyanines, and aromatic polycyclic hydrocarbons are preferred sensitizers. For applications requiring deep cure (e.g., cure of highly-filled composites), it is preferred to employ sensitizers having an extinction coefficient below about 1000, more preferably below about 100, at the desired wavelength of irradiation for photopolymerization.

By way of example, a preferred class of ketone sensitizers has the formula:

$ACO(X)_bB$

where X is CO or $CR^1R2$, where $R^1$ and $R^2$ can be the same or different, and can be hydrogen, alkyl, (preperably of up to 20 carbon atoms) alkaryl or aralkyl, b is zero or 1, and A and B can be the same or different and can be substituted (having one or more non-interfering substitutents) or unsubstituted aryl, alkyl, alkaryl, or aralkyl groups, (preferably of up to 15 carbon atoms) or together A and B can form a cyclic structure which can be a substituted or unsubstituted cycloaliphatic, aromatic, heteroaromatic or fused aromatic ring.

Suitable ketones of the above formula include monoketones (b=O) such as 2,2-, 4,4- or 2,4-dihydroxybenzophenone, di-2-pyridyl ketone, di-2-furanyl ketone, di-2-thiophenyl ketone, benzoin, fluorenone, chalcone, Michler's ketone, 2-fluoro-9-fluorenone, 2-chlorothioxanthone, acetophenone, benzophenone, 1- or 2-acetonaphthone, 9-acetylanthracene, 2-, 3-, or 9-acetylphenanthrene, 4-acetylbiphenyl, propiophenone, n-butyrophenone, valerophenone, 2-, 3- or 4-acetylpyridine, 3-acetylcoumarin and the like. Suitable diketones include arakyldiketones such as anthraquinone, phenanthraquinone, o-, m- and p-diacetylbenzene, 1,3-, 1,4-, 1,5-, 1,6- 1,7-and 1,8-diacetylnaphthalene, 1,5-, 1,8- and 9,10-diacetylanthracene, and the like. Suitable -diketones (b=1 and X=CO) include 2,3-butanedione, 2,3-pentanedione, 2,3-hexanedione, 3,4-hexanedione, 2,3-heptanedione, 3,4-heptanedione, 2,3-octanedione, 4,5-octanedione, benzil 2,2′-, 3,3′- and 4,4,-dihydroxybenzil, furil, di-3,3,-indolylethanedione, 2,3-bornanedione (camphorquinone), biacetyl, 1,2-cyclohexanedione, 1,2-naphthoquinone, acenaphthaquinone, and the like.

Preferred ketocoumarins and p-substituted aminostyryl ketone compounds are listed in Table II in said copending U.S. Pat. Appl. No. SN 34,065 and in Table I below. Preferred squarylium dyes are listed in Table I below. Preferred merocyanine dyes are listed in U.S. Patent. No. 3,729,313 and Table I below.

Table I. Sensitizers.

| Sensitizer | Structure | λmax | Dye Class |
|---|---|---|---|
| A | 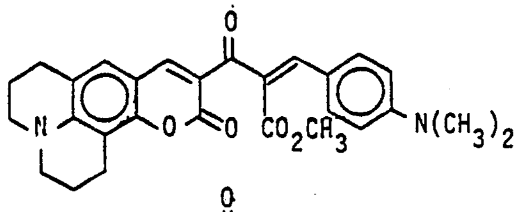 | 465 nm | ketocoumarin |
| B | 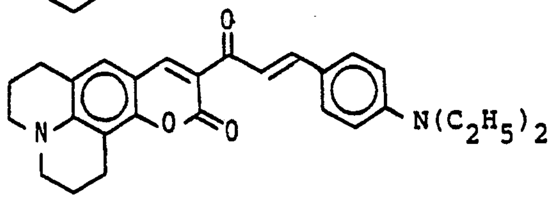 | 515 nm | ketocoumarin |
| C | 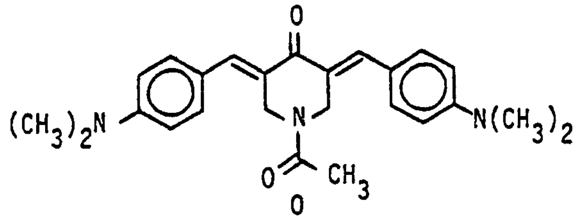 | 465 nm | aminostyryl ketone |
| D | 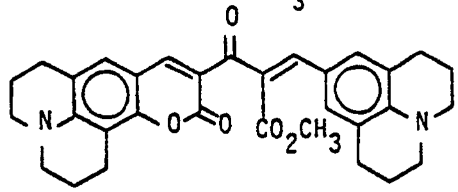 | 470 nm | ketocoumarin |
| E | 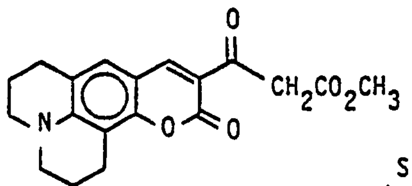 | 455 nm | ketocoumarin |
| F | 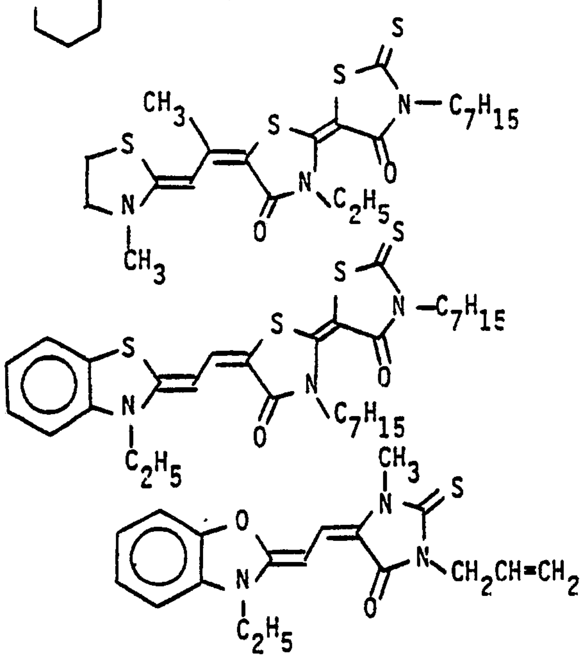 | 540 nm | merocyanine |
| G | | 571 nm | merocyanine |
| H | | 480 nm | merocyanine |

Table I. (continued)

| Sensitizer | Structure | λmax | Dye Class |
|---|---|---|---|
| I | 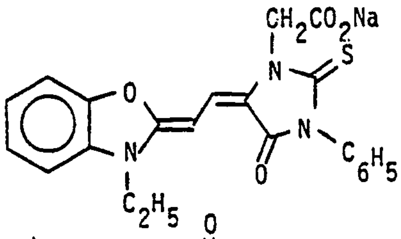 | 485 nm | merocyanine |
| J | 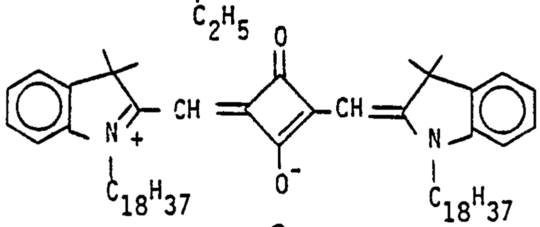 | 635 nm | squarylium |
| K | 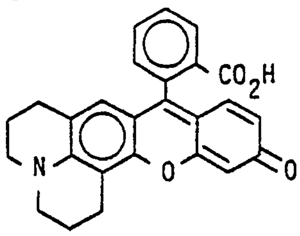 | 530 nm | xanthenone |

Table II. Donors.

| Donor | Structure | $E_{ox}$ V vs. SCE |
|---|---|---|
| A' | 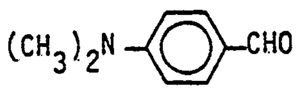 | 1.20 |
| B' | 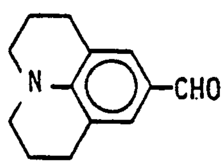 | 0.95 |
| C' | 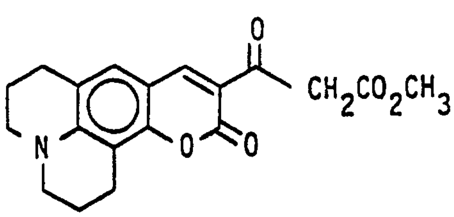 | 1.05 |
| D' | 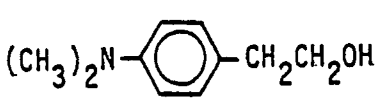 | 0.65 |

The third component in the photoinitiator system is the electron donor. A wide variety of donors can be

employed. The donor is soluble in the monomer, and should meet the oxidation potential ($E_{ox}$) limitation discussed in more detail below. Preferably, the donor also is selected based in part upon shelf stability considerations. Accordingly, selection of a particular donor may depend in part on the monomer, triazine and sensitizer chosen. Suitable donors are capable of increasing the speed of cure or depth of cure of a composition of the invention upon exposure to light of the desired wavelength. Also, the donor has an $E_{ox}$ greater than zero and less than or equal to $E_{ox}$(p-dimethoxybenzene). Preferably the $E_{ox}$ (donor) is between about 0.5 and 1 volts vs. a saturated calomel electrode ("S.C.E."). $E_{ox}$ (donor) values can be measured experimentally, or obtained from references such as N. L. Weinburg, Ed., Technique of Electroorganic Synthesis Part II Techniques of Chemistry,, Vol. V (1975), and C. K. Mann and K. K. Barnes, Electrochemical Reactions in Nonaqueous Systems (1970).

Preferred donors include amines (including aminoaldehydes and aminosilanes), amides (including phosphoramides), ethers (including thioethers), ureas (including thioureas), ferrocene, sulfinic acids and their salts, salts of ferrocyanide, ascorbic acid and its salts, dithiocarbamic acid and its salts, salts of xanthates, salts of ethylene diamine tetraacetic acid and salts of tetraphenylboronic acid. The donor can be unsubstituted or substituted with one or more non-interfering substitutents. Particularly preferred donors contain an electron donor atom such as a nitrogen, oxygen, phosphorus, or sulfur atom, and an abstractable hydrogen atom bonded to a carbon or silicon atom alpha to the electron donor atom. However if the donor compound contains an electron donor atom situated in a neutral group and selected from nitrogen, oxygen, phosphorus, and sulfur, but does not contain an abstractable hydrogen atom bonded to a carbon or silicon atom alpha to the electron donor atom, then the compound is not acceptable as an electron donor in this invention.

Preferred amine donor compounds include alkyl, aryl-, alkaryl- and aralkyl-amines such as methylamine, ethylamine, propylamine, butylamine, triethanolamine, amylamine, hexylamine, butylamine, triethanolamine, amylamine, hexylamine, 2,4-dimethylaniline, 2,3-dimethylaniline, o-, m- and p-toluidine, benzylamine, aminopyridine, N,N′-dimethylethylenediamine, N,N′-diethylethylenediamine, N,N′-dibenzylethylenediamine, N,N′-diethyl-1,3-propanediamine, N-phenylglycine, N,N′-diethyl-2-butene-1,4-diamine, N,N′-dimethyl-1,6-hexanediamine, piperazine, 4,4′-trimethylenedipiperidine, 4,4′-ethylenedipiperidine, p-N,N-dimethylaminophenethanol and p-N,N,-dimethylamino-benzonitrile; aminoaldehydes such as p-N,N-diethylaminobenzaldehyde, 9-julolidine carboxyaldehyde and and 4-morpholinobenzaldehyde; and aminosilanes such as trimethylsilylmorpholine, trimethylsilylpiperidine, bis(dimethylamino)diphenylsilane, tris(dimethylamino)methylsilane, N,N-diethylaminotrimethylsilane, tris(dimethylamino)phenylsilane, tris-(methylsilyl)amine, N,N-bis(dimethylsilyl)aniline, N-phenyl-N-dimethylsilylaniline and N N-dimethyl-N-dimethylsilylamine. Tertiary aromatic alkylamines, particularly those having at least one electron-withdrawing group on the aromatic ring, have been found to provide especially good shelf stability. Good shelf stability has also been obtained using amines that are solids at room temperature. Good photographic speed has been obtained using amines that contain one or more julolidinyl moieties.

Suitable dialkylamino and julolidinyl substituted donors are listed in Table II.

Preferred amide donor compounds include N,N-dimethylacetamide, N,N-diethylacetamide, N-methyl-N-phenylacetamide, hexamethylphosphoramide, hexaethylphosphoramide, hexapropylphosphoramide, trimorpholino-phosphine oxide,and tripiperidinophosphine oxide.

Suitable ether donor compounds include 4,4′-dimethoxybiphenyl, 1,2,4-trimethoxybenzene and 1,2,4,5-tetramethoxybenzene.

Suitable urea donor compounds include N,N-dimethylurea, N,N-dimethylurea, N,N′-diphenylurea, tetramethylthiourea, tetraethylthiourea, tetra-n-butylthiourea, N,N-di-n-butylthiourea, N,N′-di-n-butylthiourea, N,N-diphenylthiourea and N,N′-diphenyl-N,N′-diethylthiourea.

The three components of the photoinitiator system are present in "photochemically effective amounts", that is, amounts of each component sufficient to enable the monomer to undergo photochemical gelation or hardening upon exposure to light of the desired wavelength. Preferably for every 100 parts of monomer, a composition of the invention contains about 0.005 to about 10 parts (more preferably about 0.1 to about 4 parts) each of triazine, sensitizer and donor. The amounts of each component are independently variable and thus need not be equal, with larger amounts generally providing faster cure, but shorter shelf life. Sensitizers with high extinction coefficients (e.g., above about 10,000) at the desired wavelength of irradiation for photo-polymerization generally are used in reduced amounts.

The compositions of the invention can contain a wide variety of adjuvants depending upon the desired end use. Suitable adjuvants include solvents, diluents, resins, binders, plasticizers, pigments, dyes, leuco dyes, inorganic or organic reinforcing or extending fillers (at preferred amounts of about 10% to about 90% by weight, based on the total weight of the composition), thixotropic agents, indicators, inhibitors, stabilizers, UV absorbers, medicaments (e.g., leachable fluorides) and the like. The amounts and type of such

adjuvants, and their manner of addition to a composition of the invention will be familiar to those skilled in the art.

The compositions of the invention can be cured using a variety of methods. It is convenient to employ light sources that emit ultraviolet or visible light such as quartz halogen lamps, tungsten-halogen lamps, mercury lamps, Xenon and Mercury/Xenon lamps, plasma arcs, light emitting diodes and lasers. Electron beam ("E-beam") irradiation and other curing devices that do not depend on light emission can also be employed. In general, heat or an inert atmosphere will accelerate cure.

The following examples are offered to aid in understanding the invention and are not to be construed as limiting the scope thereof. Unless otherwise indicated, all parts and percentages are by weight.

## EXAMPLE 1

Solutions similar to those of U.S. Pat. No. 4,228,232 were prepared from 4.3 parts pentaerythritol tetra-acrylate (SR-295 from Sartomer Co.), 5.6 parts "Oligomer P-II" (U.S. 4,228,232, Col. 11, 61% by weight in MEK), 0.30 parts triethylamine, 14.9 parts of a dispersion containing 4.1% Pigment Red 48 (CI 15865) and 8.2% polyvinyl formal resin ("Formvar 12/85", Monsanto) in n-propanol/water azeotrope, and 74.2 parts n-propanol/water azeotrope. The amount of triethylamine was just sufficient to neutralize the acid in Oligomer P-II, and thus the triethylamine did not serve as a donor. To 2.5 parts of the above solutions were added 0.01 parts 2,4,6-tris(trichloromethyl)-1,3,5-triazine (unless otherwise specified), varying amounts of various sensitizers, and optionally various amounts of donor compound. The solutions were then coated with a #14 wire-wound rod onto grained and anodized aluminum and dried at 66 °C for 2 minutes. The resulting photosensitive printing plates were topcoated with 5% aqueous polyvinyl alcohol containing 0.026% surfactant ("Triton X-100" from Rohm and Haas) with a #10 wire-wound bar and dried at 66 °C for 2 minutes. The dried plates were exposed through a $\sqrt{2}$ density increment, 21-step sensitivity guide (Stouffer Graphic Arts) for 5 seo. using a 172,000 Lux tungsten light source ("Model 70" Transparency Maker, 3M) at a distance of 25.4 cm. The exposed plates were developed with an aqueous solution of 4% n-propanol, 2% sodium metasilicate and 0.06% surfactant ("Dowfax 2A1" from Dow Chemical Co.). Set out below in Table III are the run number, the type and amount of sensitizer, the type and amount of optional donor molecule, and the number of solid steps retained after exposure and development. Higher step values indicate greater sensitivity. Exposure values (in ergs/cm$^2$) required to form one solid step (last column in Table I) were also measured by exposing the plates to coherent light using an argon-ion laser (488 nm). Numerically lower exposure values indicate increased sensitivity.

From the data in Table III it can be seen that plates containing triazine, sensitizer, and donor are more sensitive than plates containing only triazine and sensitizer. An exposure value of 1000 ergs/cm$^2$ was obtained using a combination of triazine, ketocoumarin sensitizer (sensitizer compound A), and 9-julolidine carboxaldehyde (donor compound B′) (Run no. 4). For comparison the relatively sensitive laser-imageable composition of U.S. Patent 4,228,232 Examples 18 and 19 (cols. 18-19) have an exposure value at 488 nm of only 3,200 ergs/cm$^2$.

Table III

| | Sensitizer | | Donor | | | |
|---|---|---|---|---|---|---|
| Run No. | Type | Amount | Type | Amount | Solid Steps[a] | Sensitivity ergs/cm²[b] |
| 1 | A | .003 | none | - | 12 | 3,800 |
| 2 | A | .003 | A′ | .01 | 14 | 1,600 |
| 3[c] | A | .003 | A′ | .01 | 0 | - |
| 4 | A | .003 | B′ | .01 | 15 | 1,000 |
| 5 | B | .003 | none | - | 14 | 1,600 |
| 6 | B | .003 | B′ | .01 | 16 | 640 |
| 7 | C | .003 | none | - | 13 | - |
| 8 | C | .003 | A′ | .01 | 15 | - |

Notes to Table III:

(a) Exposure using tungsten light source.
(b) Exposure using 488 nm argon-ion laser.
(c) No triazine initiator present.

## EXAMPLE 2

Example 1 was repeated except that the dried photosensitive layer was topcoated with an aqueous solution containing 5% carboxymethyl cellulose and 0.026% surfactant (Triton X-100 from Rohm and Haas) using a #14 wire-wound rod and forced, hot-air dried. The results are set forth in Table IV.

Run nos. 4 and 5 illustrate that a sensitizer (sensitizer compound E) can also act as a donor compound (donor compound C′) in combination with another sensitizer which absorbs at longer wavelengths (sensitizer compounds A and D) than the donor compound.

Table IV

| | Sensitizer | | Donor | | | |
|---|---|---|---|---|---|---|
| Run No. | Type | Amount | Type | Amount | Solid Steps[a] | Sensitivity ergs/cm²[b] |
| 1 | E | .004 | none | - | 13 | 4,000 |
| 2 | A | .004 | none | - | 11 | 2,500 |
| 3 | D | .004 | none | - | 8 | 25,500 |
| 4 | A | .002 | C′ | .002 | 16 | 1,000 |
| 5 | D | .002 | C′ | .002 | 15 | 1,600 |

Notes to Table IV:

(a) Exposure using tungsten light source.
(b) Exposure using 488 nm argon-ion laser.

## EXAMPLE 3

A solution was prepared from 0.53 parts pentaerythritol tetraacrylate (SR-295 from Sartomer Co.), 2.0

parts of a solution containing by weight 20% of oligomer P-11 (U.S. 4,228,232 Col. 11), 13% methyl ethyl ketone and 67% 1,1,2-trichloroethane, 0.12 parts 1717 HMP resin (polyketone resin from Lawten Chemical), 0.16 parts polyvinyl formal resin (Formvar 15/95 from Monsanto Co.), and 110 parts 1,1,2-trichloroethane. To 5 parts of the above solution was added 0.003 parts of sensitizer, 0.005 parts of 2,4,6-tris-(trichloromethyl)-1,3,5-triazine, and optionally 0.006 parts of donor B′ (9-julolidine carboxaldehyde). The solutions were coated with a #10 wire-wound rod onto 4 mil polyester film and dried 1.5 min. at 60 °C. The samples were topcoated with 7% aqueous polyvinylalcohol containing 0.025% surfactant (Triton X-100 from Rohm and Haas) using a #10 wire-wound rod and dried 1.5 min. at 60 °C. The dried samples were exposed through a $\sqrt{2}$ density increment, 21-step sensitivity guide (Stouffer Graphic Arts) for 5 seconds with a 172,000 Lux tungsten light source (Model 70 Transparency Maker, 3M) at a distance of 25.4 cm. The exposed films were developed with an aqueous solution containing 0.7% sodium hydroxide and 0.2% sodium carbonate. Set out below in Table V are run number, the type of sensitizer, a statement ("yes" or "no") indicating whether or not the optional donor was added, and the number of solid steps retained after exposure and development. Higher step values indicate greater sensitivity.

Table V

| Run No. | Sensitizer | Add'l donor | Solid steps |
|---|---|---|---|
| 1 | F | No | 10 |
| 2 | F | Yes | 12 |
| 3 | G | No | 9 |
| 4 | G | Yes | 15 |
| 5 | H | No | 7 |
| 6 | H | Yes | 8 |
| 7 | I | No | 0 |
| 8 | I | Yes | 9 |
| 9 | J | No | 9 |
| 10 | J | Yes | 11 |
| 11 | K | No | 4 |
| 12 | K | Yes | 9 |

## EXAMPLE 4

A photopolymer composition was prepared consisting of 50 parts triethyleneglycol dimethacrylate, 50 parts bisphenol A diglycidyl ether dimethacrylate and 0.25 parts camphorquinone. To this solution were optionally added donor compound D′ (dimethylaminophenethyl alcohol) and 2,4,6-tris(trichloromethyl)-1,3,5-triazine. One gram of each solution was then exposed with a visible-light curing lamp ("Visilux", 3M) which was plugged into a variac whose voltage setting was 67. The solutions were stirred with a glass rod and the time required to reach the gelation point was recorded. Set out below in Table VI are the run number, weight percent of donor, weight percent triazine, and gel times.

Table VI

| Run No. | Weight % D′ | Weight % triazine | Gell time |
|---|---|---|---|
| 1 | 0.50 | 0.00 | 25 sec |
| 2 | 0.00 | 1.30 | >200 sec |
| 3 | 0.25 | 0.65 | 16 sec |

## EXAMPLE 5

To illustrate the effect of the oxidation potential of the donor upon cure speed, a series of compositions was evaluated as follows. A stock solution was prepared from 10% pentaerythritol tetraacrylate and 0.27% benzil in 4/1, w/w, acetonitrile/water. To 3 ml portions of this solution in 16x120 mm "Pyrex" test tubes was added about 0.02 g of 2,4,6-tris(trichloromethyl-1,3,5-triazine and/or 0.02g of donor compound. The solutions were purged with nitrogen for two minutes before and continuously during light exposure. The light source was a Kodak "Carousel" Projector lamp equipped with a 325 nm cutoff filter. Relative speeds were determined by measuring the time required for the solution to opacify to the point that a hole punched into a red card and placed behind the test tube could no longer be visually distinguished from its surroundings when looking through the test tube.

Set out below in TABLE VII are the run number, the donor compounds and their $E_{ox}$ in order of generally decreasing oxidation potential, and the gelation times for solutions containing benzil plus donor or benzil plus donor plus triazine. The data in TABLE VII illustrates that an increased cure rate is obtained using a composition of the invention, and demonstrates the advantage of using donors whose $E_{ox}$ value is less than or equal to that of p-dimethoxybenzene and that have an abstractable hydrogen atom on a carbon alpha to the donor atom. An exception to this latter requirement is p-toluene sulfinic acid, sodium salt.

TABLE VII

| | Donor | | Gel time, (sec) | |
|---|---|---|---|---|
| Run no. | identity | Eox | sensitizer/donor | sensitizer/donor/triazine |
| 1 | control (no donor) | - | >360 | 360 |
| 2 | 3,4-dihydro-2H-pyran | 1.61 | (a) | >360 |
| 3 | p-dimethoxy benzene | 1.34 | >360 | 320 |
| 4 | N,N-dimethylacetamide | 1.32 | (a) | >360 |
| 5 | aniline | 1.28 | (a) | >360 |
| 6 | diisopropylamine | | (a) | 214 |
| 7 | hexamethylphosphoramide | 1.00 | (a) | 230 |
| 8 | tripiperidinophosphine oxide | 1.00 | 136 | 105 |
| 9 | triethanolamine | 0.96 | 390 | 42 |
| 10 | 3-dimethylamino-1-propanol | 0.94 | >360 | 46 |
| 11 | tris[2-(2-methoxyethoxy) ethyl]amine | 0.93 | >360 | 46 |
| 12 | triphenylamine | 0.86 | (a) | >360 |
| 13 | p-diphenylaminobenzaldehyde | | (a) | >360 |
| 14 | p-toluene sulfinic acid, sodium salt | 0.76 | 130 | 8 |
| 15 | p-dimethylaminobenzaldehyde | 0.70 | >360 | 227 |
| (a) Not determined. | | | | |

## EXAMPLE 6

This example illustrates the increased cure rate for a series of visible light-absorbing sensitizers when incorporated into a composition of the invention consisting of sensitizer/initiator/donor. A monomer stock solution was prepared from 10% pentaerythritol tetraacrylate in 4/1, w/w, acetonitrile/water. To 3 ml portions of this solution in 16x120 mm "Pyrex" test tubes were added about 0.02 g of 2-methyl-4,6-bis-(trichloromethyl)-1,3,5-triazine and/or 0.02 g p-toluene sulfinic acid, sodium salt, and enough sensitizer to give an optical density of between 1 and 2, as evaluated visually. The solutions were purged, exposed and evaluated as in EXAMPLE 5.

Set out below in TABLE VIII are the run number, the sensitizers and their absorption màxima, and the gelation times for solutions containing triazine plus sensitizer, sensitizer plus donor, or triazine plus

sensitizer plus donor.

TABLE VIII

| Run no. | Sensitizer identity | max | Gel time, sec triazine/sensitizer | sensitizer/donor | triazine/sensitizer/donor |
|---|---|---|---|---|---|
| 1 | IR-140 | 823 | >360 | >360 | 177 |
| 2 | methylene blue | 663 | >360 | >360 | 16 |
| 3 | thionin | 598 | >360 | >360 | 31 |
| 4 | sulforhodamine B | 554 | (a) | (a) | 89 |
| 5 | 3,3′-dimethylthiocarbocyanine iodide | 553 | (a) | >360 | 47 |
| 6 | rose bengal | 548 | >360 | 85 | 7 |
| 7 | 1-methylaminoanthraqinone | 502 | >360 | >360 | 68 |
| 8 | fluorescein | 491 | >360 | >360 | 12 |
| 9 | acridine orange | 488 | 250 | (a) | 8 |
| 10 | tris(bipyridyl)ruthenium (+2) chloride | 453 | >360 | 226 | 11 |

(a) Not determined.

EXAMPLE 7

To illustrate the effect of donor with various halogenated initiator/sensitizer combinations, a series of compositions was evaluated as follows. A monomer stock solution was prepared from 10% pentaerythritol tetraacrylate in 4/1, w/w, acetonitrile/water. To 3 ml portions of this solution in 16x120 mm "Pyrex" test tubes were added about 0.02 g p-toluene sulfinic acid, sodium salt, and/or 0.02 g initiator and enough thionin to give an optical density of between 1 and 2, as evaluated visually. The samples were purged, exposed and evaluated for relative cure speed as in EXAMPLE 5.

Set out below in TABLE IX are the run number, the initiator, and the gelation times for solutions containing thionin plus initiator or thionin plus initiator plus p-toluene sulfinic acid, sodium salt.

TABLE IX

| | | Gel time, sec. | |
|---|---|---|---|
| Run no. | Initiator | sensitizer/Initiator | sensitizer/donor/Initiator |
| 1 | 2,4,6-tris(trichloromethyl)-1,3,5-triazine | >360 | 5 |
| 2 | 2,4,6-tris(tribromomethyl)-1,3,5-triazine | >360 | 39 |
| 3 | 2-methyl-4,6-bis(trichloromethyl)-1,3,5-triazine | >360 | 31 |
| 4 | 2-(4-methoxyphenyl)-4,6-bis(trichloromethyl)-1,3,5-triazine | >360 | 47 |

## Claims

1. An addition-polymerizable composition comprising:

a) free-radically-polymerizable monomer, and

b) photoinitiator system, compatible with said monomer, comprising photochemically effective amounts

i) at least one trihalomethyl-substituted 1,3,5-triazine

ii) at least one sensitizing compound capable of absorbing at least some radiation between about 300 and about 1000 nanometers and which sensitizing compound spectrally sensitizes 2-methyl-4,6-bis-(trichloromethyl)-s-triazine, and

iii) at least one electron donor compound selected from a) compounds wherein the donor atoms are situated in a charged group, and b) compounds wherein the donor atoms are situated in a neutral group and wherein there is an abstractable hydrogen atom bonded to a carbon or silicon atom alpha to the donor atom, said donor atoms being selected from nitrogen, oxygen, phosphorus, and sulfur, said electron donor compound being different from said sensitizing compound and having an oxidation potential which is greater than zero and less than that of p-dimethoxybenzene.

2. A composition according to claim 1 wherein said triazine is selected from those having the general structure

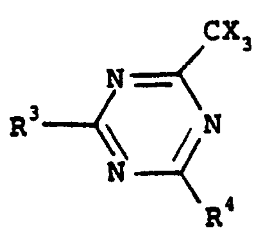

where X is Cl or Br, $R^3$, $R^4$ are independently $CX_3$, $R^5$, $R^5NH$-, or $R^5CONH$-, wherein $R^5$ is alkyl of 1 to 8 carbons, substituted alkyl of not more than 12 carbons, phenyl, substituted phenyl of not more than 12 carbon atoms, naphthyl, or substituted naphthyl of not more than 14 carbons.

3. A composition according to claim 1, wherein said sensitizing compound is selected from the group consisting of ketones, coumarin dyes, ketocoumarin dyes, xanthene dyes, xanthenone dyes, acridine dyes, thiazole dyes, thiazine dyes, oxazine dyes, azine dyes, aminoketone dyes, porphyrins, aromatic polycyclic hydrocarbons, p-substituted aminostyryl ketone compounds, aminotriaryl methanes, cyanines, merocyanines, squarylium dyes and pyridinium dyes.

4. A composition according to claim 1, wherein said sensitizing compound contains at least one julolidinyl moiety.

5. A composition according to claim 1, wherein said sensitizing compound comprises an alpha-diketone having an extinction coefficient below about 1000 at the wavelength at which said composition is irradiated when photopolymerized.

6. A compostion according to claim 1, wherein said sensitizing compound has the formula:

$ACO(X)_bB$

where X is CO or $CR^1R^2$, where $R^1$ and $R^2$ can be the same or different, and can be hydrogen, alkyl, alkaryl or aralkyl, b is zero or 1, and A and B can be the same or different and can be substituted or unsubstituted aryl, alkyl, alkaryl or aralkyl groups, or together A and B can form a cyclic structure which can be a substituted or unsubstituted cycloaliphatic, aromatic, heteroaromatic or fused aromatic ring.

7. A composition according to claim 1, wherein said donor is selected from the group consisting of amines, amides, ethers, ureas, ferrocene, sulfinic acids and their salts, salts of ferrocyanide, ascorbic acid and its salts, dithiocarbamic acid and its salts, salts of xanthates, salts of ethylene diamine tetraacetic acid and salts of tetraphenylboronio acid.

8. A composition according to claim 1, wherein said donor contains a nitrogen, oxygen, phosphorus or sulfur donor atom in a neutral group and an abstractable hydrogen atom bonded to a carbon or silicon atom alpha to said donor atom.

9. A composition according to claim 1, wherein said donor contains one or more julolidinyl moieties.

10. A method for addition photopolymerization comprising the step of irradiating a composition with light having a wavelength between about 300 and about 1000 nanometers until said composition gels or hardens, said composition comprising:

a) free-radically-polymerizable monomer, and

b) photoinitiator system, compatible with said monomer, comprising photochemically effective amounts of

i) trihalomethyl substituted 1,3,5-triazine,

ii) sensitizing compound capable of absorbing light somewhere within the range of wavelengths between about 300 and about 1000 nanometers and capable of sensitizing 2-methyl-4,6-bis(trichloromethyl)-s-triazine, and

iii) electron donor compound selected from a) compounds wherein the donor atoms are situated in a charged group, and b) compounds wherein the donor atoms are situated in a neutral group and wherein there is an abstractable hydrogen atom bonded to a carbon or silicon atom alpha to the donor atom, said donor atoms being selected from nitrogen, oxygen, phosphorus, and sulfur, said electron donor compound being different from said sensitizing compound and from said trihalomethyl substituted 1,3,5-triazine, and zero $<E_{ox}$ (donor) $<E_{ox}$ (p-dimethoxybenzene).

11. An addition-polymerizable composition comprising:

a) free-radically-polymerizable monomer, and

b) photoinitiator system, soluble in said monomer, comprising 0.1 to 4 parts each of

i) trihalomethyl substituted 1,3,5-triazine

ii) ketone, ketocoumarin, aminoarylketone, p-substituted aminostyryl ketone, merocyanine, squarylium, or aromatic polycyclic hydrocarbon sensitizing compound capable of absorbing light somewhere within the range of wavelengths between about 350 and about 700 nanometers and capable of sensitizing 2-methyl-4,6-bis(trichloromethyl)-s-traizine, and

iii) electron donor compound containing a nitrogen donor atom in a neutral group and having an abstractable hydrogen atom bonded to a carbon or silicon atom alpha to said nitrogen atom, wherein said donor compound is different from said sensitizing compound and wherein about 0.5 $< e_{ox}$ (donor) $</=$ about 1 volt vs. a saturated calomel electrode.

European Patent Office

# EUROPEAN SEARCH REPORT

Application Number

EP 89 31 1352

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | GB-A-2 029 428 (FUJI PHOTO FILM CO., LTD)<br>* Page 1, lines 25-41; pages 7-17; tables and examples *<br>--- | 1-6,10 | G 03 F 7/029 |
| Y | GB-A-1 146 497 (DU PONT DE NEMOURS)<br>* Claims; page 1, lines 48-57; page 2, lines 75-79 *<br>--- | 1,7,8 | |
| A,D | US-A-4 505 793 (K. TAMOTO et al.)<br>* Whole document *<br>--- | 1-6 | |
| A | CHEMICAL ABSTRACTS, vol. 109, no. 6, 8th August 1988, page 577, abstract no. 46213u, Columbus, Ohio, US; & JP-A-88 32 540 (FUJI PHOTO FILM CO.) 12th February 1988<br>* Abstract *<br>----- | 1,7 | |
| | | | TECHNICAL FIELDS SEARCHED (Int. Cl.5) |
| | | | G 03 F 7/00 |

The present search report has been drawn up for all claims

| Place of search | Date of completion of the search | Examiner |
|---|---|---|
| THE HAGUE | 21-12-1989 | LUDI M.M.B. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document